# EUROPEAN PATENT APPLICATION

(11) **EP 2 456 288 A1**
(43) Date of publication of application: **23.05.2012**
(21) Application number: 10811403.4
(22) Date of filing: 08.04.2010
(51) Int. Cl.: H05B 33/26, C23C 14/14, C23C 14/34, H01L 51/50, H05B 33/06, H05B 33/10, H05B 33/14

(54) **EL LIGHT EMITTING DEVICE AND METHOD FOR MANUFACTURING SAME**

(30) Priority: 26.08.2009 JP 2009195580
(71) Applicant: Sharp Kabushiki Kaisha, Osaka-shi, Osaka 545-8522 (JP)
(72) Inventor: HIRAI, Masaaki, Osaka-shi OSAKA 545-8522 (JP)
(74) Representative: Müller-Boré & Partner Patentanwälte
(86) International application number: PCT/JP2010/002581
(87) International publication number: WO 2011/024343

(57) **Abstract**

The present invention improves mechanical strength of an electrode and provides an EL device etc. with excellent durability.

An EL device includes a pair of electrodes 11 and 12 on a substrate 2, and a light emitting layer 15 provided between the electrodes 11 and 12. One of the pair of electrodes 11 and 12 is a metal electrode. The metal electrode is a multilayer including a lower layer 20 of aluminum metal and an upper layer 21 of nickel metal formed above the lower layer. Only the upper layer 21 of the lower layer 20 and the upper layer 21 contains a nitrogen element derived from sputtering gas. As the material of the upper layer 21, for example, an alloy of nickel and copper is preferable.

## Description

### TECHNICAL FIELD

The present disclosure relates to electroluminescence (EL) devices and manufacturing methods of the devices, and more particularly to techniques of forming metal electrodes.

### BACKGROUND ART

EL devices such as EL displays are divided into an inorganic EL device including an inorganic compound as the material of a light emitting layer, and an organic EL device including an organic compound. Each of the EL devices usually includes, as a basic structure, a substrate as a base and an EL element in the form of a thin film provided on the substrate. In an EL display, an EL element includes a pair of intersecting upper and lower electrodes, and a light emitting layer provided between the electrodes. Moving images etc. are displayed utilizing the nature that a light emitting layer emits light when a voltage is applied between the electrodes.

Electrodes of an EL device are often made of ITO, aluminum, etc. For example, when the EL device is of a bottom emission type which emits light from a substrate, an electrode (i.e., lower electrode) at the side of the substrate is a transparent electrode made of ITO etc., and an electrode (i.e., upper electrode) at the other side is a metal electrode made of aluminum etc. The reverse structure is used when the EL device is of a top emission type which emits light from the side opposite to the substrate.

As one of the metal electrodes, a metal electrode formed by stacking metal layers of different materials is suggested (Patent Document 1). The metal electrode is formed by stacking a cap metal layer and a barrier metal layer on and under an aluminum metal layer, respectively. The cap metal layer and the barrier metal layer are made of molybdenum nitride. The cap metal layer etc. is formed by sputtering, and the flow rate of nitrogen added to sputtering gas is changed when forming the film so that the cap metal layer has a different nitrogen concentration from the barrier metal layer.

### CITATION LIST

### PATENT DOCUMENT

Japanese Patent Publication No. 2000-147550

### SUMMARY OF THE INVENTION

### TECHNICAL PROBLEM

Since aluminum and its alloys (aluminum metal) have relatively low hardness, an electrode of aluminum metal has the problem of low mechanical strength. For example, when an upper electrode is made of aluminum metal and electrical connection is obtained by a contact between the upper electrode and a terminal at the side of a plug, the upper electrode tends to be worn away in friction with the terminal at the side of the plug, and satisfactory durability is thus difficult to obtain.

In view of the problems, the present inventors attempted to coat a surface of aluminum metal by sputtering using nickel and its alloys (nickel metal) having higher hardness than aluminum metal. However, when aluminum metal was coated with nickel metal, there was the problem that the thickness of the nickel metal could not increase to an appropriate value under practical conditions in subsequent etching, since the etching rate of the nickel metal was low (a half or less of aluminum metal) and too much time was required for the etching.

It is an objective of the present invention to improve the mechanical strength of an electrode and to provide an EL device etc. with excellent durability by coating aluminum metal with nickel metal with a suited thickness under practical conditions.

### SOLUTION TO THE PROBLEM

In order to achieve the objective, a formation method of an electrode is developed in the present invention. Specifically, an EL device according to the present invention includes a substrate; a pair of electrodes provided one above the other on the substrate; and a light emitting layer provided between the pair of electrodes. A voltage is applied between the pair of electrodes to emit light from the light emitting layer. At least one of the pair of electrodes is a metal electrode. The metal electrode is a multilayer including a lower layer of aluminum metal, and an upper layer of nickel metal formed above the lower layer. Only the upper layer of the upper and lower layers contains a nitrogen element.

According to the EL device, the metal electrode is the multilayer including the lower layer of aluminum metal and the upper layer of nickel metal formed above the lower layer. Therefore, while aluminum metal tends to be oxidized, the oxidation of the aluminum metal can be reduced by coating the aluminum metal with nickel metal. Also, although aluminum metal has relatively low hardness and thus tends to be damaged, the mechanical strength of the metal electrode can be improved by coating the aluminum metal with nickel metal.

Only the upper layer of the upper and lower layers contains the nitrogen element. When the nickel metal of the upper layer containing the nitrogen element is used as a metal electrode, the mechanical strength can be sufficiently improved under practical conditions, thereby increasing the durability of the EL device.

Although details will be described later, since nickel metal is etched at a lower rate than aluminum metal, too much time is needed for etching to increase the thickness of the nickel metal film to an appropriate value under the practical conditions.

However, after repetitive considerations, the present inventors found that the etching rate is increased by adding nitrogen gas to sputtering gas when sputtering nickel metal. Specifically, a predetermined amount of nitrogen gas is added to sputtering gas used when sputtering nickel metal, thereby enabling an increase in the thickness of the nickel metal to an appropriate value even under practical conditions.

When nitrogen gas is added to sputtering gas as described above, a nitrogen element derived from the added nitrogen gas is contained in the nickel metal of the upper layer.

Specifically, a thickness of the upper layer is preferably set to 100 nm or more. Then, the nickel metal appropriately protects the aluminum metal, thereby providing an EL device with excellent durability.

The upper layer may be made of, for example, an alloy of nickel and copper. Then, the etching rate is increased and easily controlled by adding the nitrogen gas to the sputtering gas, thereby forming a high-quality metal electrode.

In particular, the EL device preferably further includes a terminal section connected to a body to be connected, which includes a connection terminal, in a removable manner. Part of the metal electrode is preferably provided in the terminal section in friction with the connection terminal. This is because sufficient durability can be obtained even when the surface of the metal electrode is repeatedly rubbed, since the surface of the metal electrode is appropriately coated with nickel metal.

The EL device with this structure is manufactured by a method including, for example, the steps of: forming a lower electrode, which is one of the pair of electrodes and is positioned lower, on the substrate; forming the light emitting layer on the substrate provided with the lower electrode; and forming an upper electrode, which is the other one of the pair of electrodes and is positioned higher, on the substrate provided with the lower electrode and the light emitting layer. At least one of the step of forming the lower electrode or the step of forming the upper electrode includes the steps of sputtering for forming the aluminum metal layer and the nickel metal layer above the aluminum metal layer to form a multilayer film, and etching for patterning the multilayer film. In the step of sputtering, nitrogen gas is added to sputtering gas only when forming the nickel metal film.

Specifically, an additive amount of the nitrogen gas can be set in a range of 1% to 30% by weight. In this range, the etching rate of the nickel metal changes as a linear function according to the additive amount of the nitrogen gas. The etching rate can be thus easily controlled and an appropriate etching rate can be freely determined. The edge shape of the nickel metal film can be changed as appropriate.

In particular, the additive amount of the nitrogen gas in the step of sputtering is preferably set so that the aluminum metal film has an etching rate substantially equal to an etching rate of the nickel metal film in the step of etching. Specifically, the additive amount of the nitrogen gas may be set in a range of 6% to 8% by weight.

Then, the multilayer film can be continuously etched without changing the conditions, and etching is thus easily performed. In addition, the metal electrodes after the etching can have sharp forms with few gaps in the edge (edge portion).

### ADVANTAGES OF THE INVENTION

As described above, according to the present invention, the thickness of the nickel metal film can be freely set without limits, and the aluminum metal film is coated with the nickel metal film under practical conditions, thereby improving the mechanical strength of the electrodes and providing an EL device etc. with excellent durability.

### BRIEF DESCRIPTION OF THE DRAWINGS

[FIG. 1] FIG. 1 is a schematic perspective view illustrating a main portion of an EL device according to an embodiment. Part of the figure shows a cross-sectional structure.
[FIG. 2] FIG. 2 is a schematic cross-sectional view illustrating a main portion of the EL device according to the embodiment.
[FIG. 3] FIG. 3 is a graph illustrating the relationship between an etching rate of nickel metal in etching and an amount of nitrogen gas added to sputtering gas in sputtering.
[FIG. 4] FIGS. 4A and 4B are enlarged photographs illustrating an upper electrode according to embodiments. FIG. 4A illustrates a first embodiment. FIG. 4B illustrates a second embodiment.

### DESCRIPTION OF EMBODIMENTS

Embodiments of the present invention will be described hereinafter with reference to the drawings. Basically, the following description is merely an example, and does not limit the scope, applications, and use of the present invention.

### EL Device

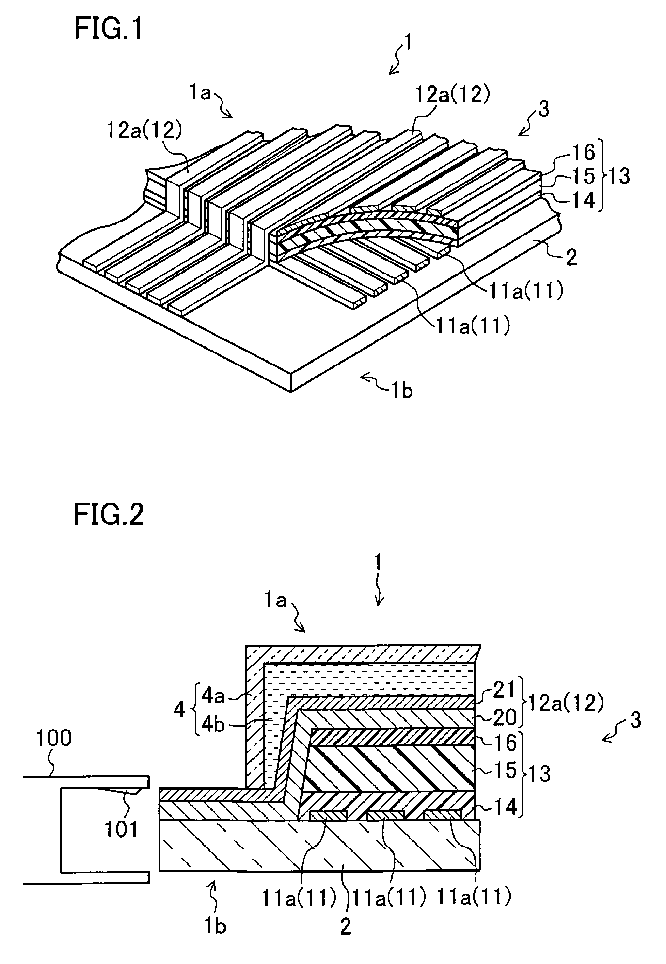

FIGS. 1 and 2 illustrate an EL display 1 (EL device) employing the present invention. This EL display 1 is an inorganic EL display 1 (hereinafter simply referred to as a "display 1") including an inorganic compound as the material of a light emitting layer. The display 1 is provided with an element film 3, which is a thin film, to be stacked on a substantial rectangle substrate 2 serving as a base. A display section 1a, which displays moving images etc., is largely provided in the central portion of the display 1. A terminal section 1b is provided at the end of the display 1 to extend along the edge.

The display 1 according to this embodiment is of a bottom emission type in which light of a light emitting layer 15 is picked up from the substrate 2. The substrate 2 is a glass substrate with excellent translucency. The thickness of the substrate 2 can be set in, for example, the range of 1 to 3 mm.

The element film 3 includes a pair of a lower electrode 11 and an upper electrode 12, a group 13 of light emitting layers of a lower insulating layer 14, the light emitting layer 15, and an upper insulating layer 16, etc. The lower insulating layer 14 and the upper insulating layer 16 function as dielectric layers. These layers are stacked one on the other in the display section 1a. Specifically, as shown in FIG. 2 in detail, the group 13 of light emitting layers is provided between the pair of electrodes 11 and 12. The lower electrode 11, the lower insulating layer 14, the light emitting layer 15, the upper insulating layer 16, and the upper electrode 12 are sequentially stacked on the substrate 2 from bottom.

The lower electrode 11 is a transparent electrode made of ITO. The lower electrode 11 includes a plurality of strip-shape electrodes (lower strip electrodes 11a). These lower strip electrodes 11 a, 11 a, ... , are provided on the substrate 2 at predetermined intervals to extend parallel to each other. The thickness of the lower electrode 11 may be set in, for example, the range of 100 to 200 nm.

The lower insulating layer 14 is made of, for example, silicon dioxide (SiO₂), aluminum oxide (Al₂O₃), titanium dioxide (TiO₂), silicon nitride (Si₃N₄), etc. and is provided to coat the lower electrode 11. The lower insulating layer 14 may be a single layer made of a single material, or may be a multilayer formed by stacking a plurality of materials. For example, the lower insulating layer 14 according to this embodiment is a double layer (not shown) formed by stacking a silicon nitride layer on a silicon dioxide layer. The thickness of the lower insulating layer 14 may be set in, for example, the range of 100 nm to 300 nm.

The light emitting layer 15 is made of zinc sulfide (ZnS) doped with manganese (Mn). The thickness of the light emitting layer 15 may be set in, for example, the range of 500 to 1000 nm.

Similar to the lower insulating layer 14, the upper insulating layer 16 is made of, for example, silicon dioxide etc. and is provided to coat the light emitting layer 15. The thickness of the upper insulating layer 16 may be also set in, for example, the range of 100 nm to 300 nm.

The upper electrode 12 is a metal electrode made of metal, and is a double layer of a lower layer 20 of aluminum metal and an upper layer 21 of nickel metal formed above the lower layer in this embodiment. Specifically, the lower layer 20 is made of aluminum (Al) or its alloy, and the upper layer 21 is made of nickel (Ni) or its alloy.

The upper electrode 12 is formed by such the multilayer, thereby providing the following advantages. First, although aluminum metal tends to be oxidized, the oxidation can be reduced by coating the aluminum metal with nickel metal. Second, although aluminum metal has relatively low hardness and tends to be damaged, the mechanical strength of the upper electrode 12 can be improved by coating the aluminum metal with nickel metal.

In this embodiment, the lower layer 20 is made of an alloy (Al-Nd) of aluminum and neodymium, and the upper layer 21 is made of an alloy (Ni-Cu) of nickel and copper. The mixture ratio of neodymium to aluminum in the lower layer 20 can be set in the range of 5 to 10% by weight. The mixture ratio of copper to nickel in the upper layer 21 can be set in the range of 10 to 20% by weight. The thickness of the lower layer 20 can be set in the range of 200 to 500 nm. The thickness of the upper layer 21 can be set in the range of 100 nm to 300 nm. In particular, when the thickness of the upper layer 21 is smaller than 100 nm, satisfactory mechanical strength may not be obtained under the influence of variations in film formation, etc. When it is greater than 300 nm, an excessive thickness induces a rise in material costs.

Only the upper layer 21 of the lower layer 20 and the upper layer 21 contains a nitrogen element. Specifically, although the details will be described later, nitrogen gas exists in the atmosphere when forming the nickel metal film of the upper layer 21, and as a result, an extremely small amount of a nitrogen element is contained in the nickel metal film under the influence of the nitrogen gas. On the other hand, no nitrogen gas exists in the atmosphere when forming the aluminum metal of the lower layer 20, and the aluminum metal contains thus no nitrogen element.

Similar to the lower electrode 11, the upper electrode 12 includes a plurality of strip-shape electrodes (upper strip electrodes 12a). These upper strip electrodes 12a, 12a, ... , are arranged to extend parallel to each other at predetermined intervals to be substantially perpendicular to the lower strip electrodes 11 a. One ends of the upper strip electrodes 12a, 12a, ... , extends to the top surface of the terminal section 1b.

As shown in, for example, FIG. 2, the terminal section 1b is removable from an external plug 100 (a body to be connected) having a plurality of connection terminals 101 which are freely slidable in and out. Since the ends of the upper strip electrodes 12a are provided on the top surface of the terminal section 1b, the terminal section 1b is in friction and contact with predetermined ones of the connection terminals 101 of the plug 100 when the terminal section 1b is inserted into the plug 100. As such, the terminal section 1b is connected to the plug 100, thereby electrically connecting the upper electrode 12 to an external wiring. Although not described, the lower electrode 11 is similarly electrically connected to an external wiring. The display 1 connected to the external wirings in this manner displays moving images etc. utilizing the feature that the intersection in the light emitting layer 15 between a predetermined one of the upper strip electrodes 12a and a predetermined one of the lower strip electrodes 11 a emits light when voltages are applied to the predetermined ones of the upper and lower strip electrodes.

The display section 1a is, as shown in FIG. 2 only, provided with a moisture-proof member 4 in addition to the element film 3. Specifically, a tray-like sealing glass 4a is bonded onto the substrate 2 so as to cover the element film 3 of the display section 1a. Thus, the group 13 of light emitting layers provided on the display section 1a is blocked from the air. The sealing glass 4a is attached to the substrate 2 in a watertight manner. A moisture-proof agent 4b such as silicon oil is enclosed in a gap between the sealing glass 4a and the substrate 2. As such, the moisture-proof member 4 is provided to reduce moisture absorption of zinc sulfide and reduce degradation in the performance of the light emitting layer 15, since zinc sulfide of the light emitting layer 15 has high moisture absorbency.

### Manufacturing Method of EL Device

The display 1 with the above-described structure can be manufactured by, for example, the following manufacturing method.

### Step of Forming Lower Electrode

In this step, the lower electrode 11 is formed on the substrate 2. Specifically, an ITO film is formed on the substrate 2 with a predetermined thickness by magnetron sputtering. After the film formation, patterning is performed by photolithography so that the lower electrode 11 is formed on the substrate 2 in a predetermined form.

### Step of Forming Group of Light Emitting Layers

In this step, the group 13 of light emitting layers is formed on the substrate 2 provided with the lower electrode 11. Specifically, after forming the lower electrode 11, a silicon dioxide film with a predetermined thickness is formed on the lower electrode by magnetron sputtering. Then, a silicon nitride film with a predetermined thickness is continuously formed on the silicon dioxide film by magnetron sputtering to form the lower insulating layer 14 which is a double layer. The lower insulating layer 14 is formed only in the display section 1 a by using, for example, a mask.

After that, zinc sulfide doped with manganese is deposited on the lower insulating layer 14 by magnetron sputtering or electron beam deposition to form the light emitting layer 15 with a predetermined thickness. A mask is also used for forming the light emitting layer 15.

Then, a silicon nitride film with a predetermined thickness is formed on the light emitting layer 15 by magnetron sputtering to form the upper insulating layer 16. Similar to the lower insulating layer 14, the upper insulating layer 16 is formed only in the display section 1 a by using, for example, a mask.

### Step of Forming Upper Electrode

In this step, the upper electrode 12 is formed on the substrate 2 provided with the lower electrode 11 and the group 13 of light emitting layers. Specifically, an Al-Nd film with a predetermined thickness is formed on the upper insulating layer 16 by magnetron sputtering. Then, a Ni-Cu film with a predetermined thickness is continuously formed on the Al-Nd film to form a double-layer film (a multilayer film)(hereinafter referred to as a "step of sputtering"). In the step of sputtering, argon (Ar) gas etc. is used as sputtering gas filled in the atmosphere. Note that a predetermined amount of nitrogen gas is added to the argon gas etc., only when forming the Ni-Cu film of the upper layer 21. For example, the amount of the nitrogen gas added to the argon gas etc., is set in the range of 1 to 30% by weight. In particular, it is preferably set in the range of 6 to 8% by weight.

The formed multilayer film is patterned by photolithography to form the upper electrode 12 in a predetermined form. Specifically, the multilayer film is etched with, for example, a phosphate/nitrate etchant produced by mixing phosphoric acid and nitric acid in a predetermined ratio (at a temperature of 40°C) to pattern the multilayer film in the predetermined form (hereinafter referred to as a "step of etching").

In a conventional method implemented without adding nitrogen gas, since the etching rate of the Ni-Cu film is less than half of the etching rate of the Al-Nd film, too much time is required for etching, and the thickness of the Ni-Cu film cannot be increased to 100 nm or more under practical conditions. After repetitive considerations for increasing the etching rate of a Ni-Cu film, the present inventors found that when adding nitrogen gas to sputtering gas used for forming a Ni-Cu film and controlling the amount of the nitrogen gas, the etching rate increases according to the amount of the nitrogen gas.

Based on the finding, in this step, the predetermined amount of the nitrogen gas is added to the sputtering gas only when forming the Ni-Cu film to increase the etching rate of the Ni-Cu film to a predetermined value in the subsequent step of etching.

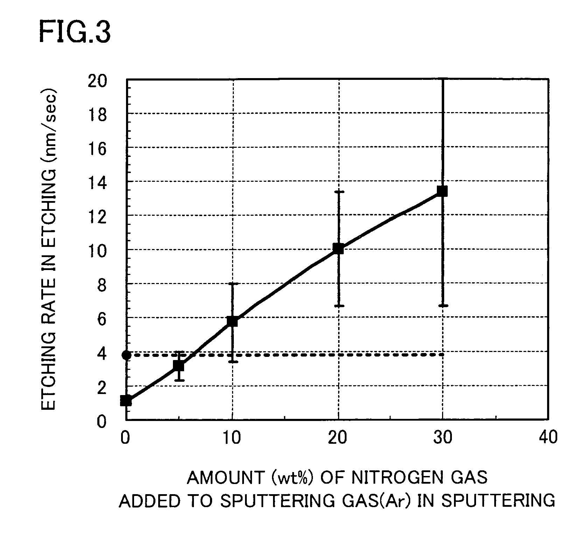

For example, FIG. 3 is a graph illustrating the relationship in the Ni-Cu film between the amount (represented by the horizontal axis) of the nitrogen gas added to the sputtering (Ar) gas in the sputtering and the etching rate (represented by the vertical axis) in the etching. In the graph, the solid line with black squares as measurement points represents the Ni-Cu film, and black circles and the broken line extended horizontally for comparison represent the Al-Nd film. The mixture ratio of Nd to Al in the Al-Nd film is 3% by weight, and the mixture ratio of Cu to Ni in the Ni-Cu film is 15% by weight.

When no nitrogen gas is added, the etching rate (about 1 nm/sec) of the Ni-Cu film is less than half of the etching rate (about 4 nm/sec) of the Al-Nd film. When the nitrogen gas is added, the etching rate increases as a linear function according to the additive amount, and is more than three times (about 13 nm/sec) of the etching rate of the Al-Nd film when the additive amount reaches 30% by weight. When the additive amount of the nitrogen gas is about 7% by weight, the etching rate of the Ni-Cu film is about 4 nm/sec which is nearly equal to the etching rate of the Al-Nd film.

Therefore, the etching rate of the Ni-Cu film increases by adding the nitrogen gas to the sputtering gas. For example, by controlling the additive amount within the range of 1 to 30% by weight, the etching rate of the Ni-Cu film can be freely controlled to about three times of the etching rate of the Al-Nd film. Although details will be described later, for example, when the additive amount of the nitrogen gas is increased so that the Ni-Cu film is etched at a higher rate than the Al-Nd film, the edge (edge portion) of the upper layer of the Ni-Cu film relatively backs away to provide an upward slope (taper) at the edge of the electrode. On the other hand, when the additive amount of the nitrogen gas is reduced so that the Ni-Cu film is etched at a lower rate than the Al-Nd film, the edge (edge portion) of the lower layer of the Al-Nd film relatively backs away to provide a downward slope (reverse taper) at the edge of the electrode.

In particular, when the additive amount of the nitrogen gas is set in a range of 6 to 8% by weight, the etching rate of the Ni-Cu film can be nearly equal to the etching rate of the Al-Nd film. Then, the both films can be continuously etched under the same conditions in the etching without distinction, and the etching can be thus facilitated. Also, the edges overlap and the forms after the etching can be almost the same, thereby forming an electrode with few gaps.

As such, by adding the nitrogen gas to the sputtering gas, the etching rate of the Ni-Cu film increases, thereby freely controlling the rate. As a result, the thickness of the Ni-Cu film can be sufficiently increased even under practical conditions. Since the thickness and the form can be controlled as appropriate, a high-quality electrode with excellent mechanical strength can be formed.

### Embodiment

Under the same conditions, the lower electrode 11, the light emitting layer 15, etc. with the above-described structures were formed on the glass substrate 2. When forming the upper electrode 12, sputtering was performed while setting the additive amount of the nitrogen gas to 5% by weight in a first embodiment. In a second embodiment, sputtering was performed while setting the additive amount of the nitrogen gas to 20% by weight. In both cases, the multilayer films of the embodiments were formed using the Al-Nd film, in which the mixture ratio of Nd to Al was 3% by weight, and the Ni-Cu film, in which the mixture ratio of Cu to Ni was 15% by weight; and setting the thicknesses to 400 nm and 200 nm, respectively.

After that, these multilayer films were etched using the above-described predetermined etchants. In the first embodiment, etching could be performed for almost the same time as in the case where an Al-Nd film with a thickness of 600 nm was formed, and etching could be completed for a time, which was not problematic in practical, even when a Ni-Cu film with a thickness of 200 nm was used. In the second embodiment, etching could be completed for a time shorter than that in the first embodiment, thereby further reducing the time for manufacture.

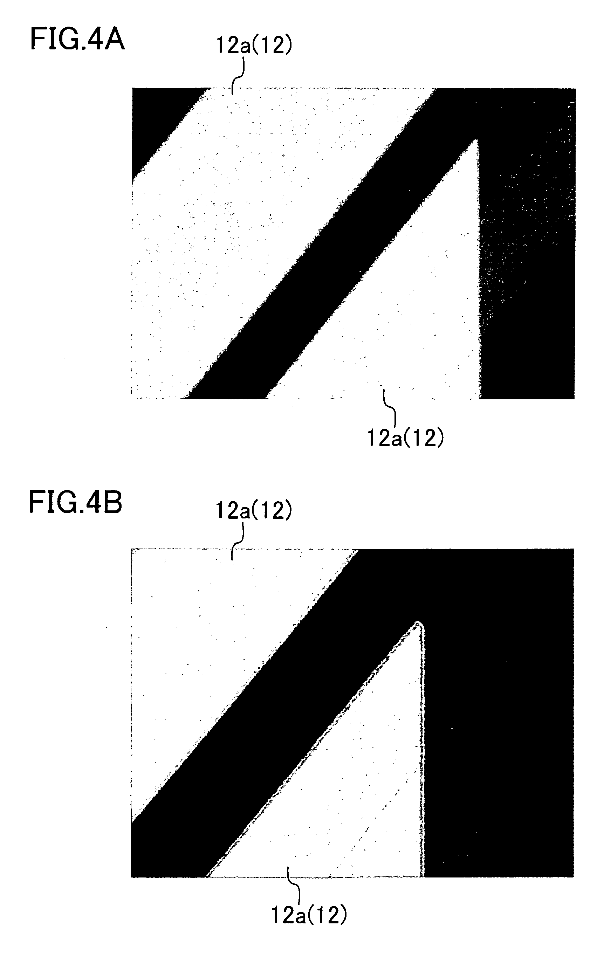

FIGS. 4A and 4B are enlarged photographs illustrating the states of the upper electrode 12 after etching in the embodiments. FIG. 4A illustrates the electrode of the first embodiment, and FIG. 4B illustrates the electrode of the second embodiment. The both photographs show the top surfaces of the upper electrodes 12a (12) taken from above. The Ni-Cu film of the upper layer 21 is located at the front.

As shown in FIG. 4B, the edge portion of the Ni-Cu film backs away (has a tapered shape) in the second embodiment where the great amount of the nitrogen gas is added, and the Ni-Cu film is etched at a higher rate than the Al-Nd film. On the other hand, such backaway of the edge portion is not recognized (a slight reverse taper would be found) in the first embodiment where the amount of the nitrogen gas is small, and Ni-Cu film is etched at a lower rate than the Al-Nd film. Therefore, it is found from this result that the edge forms of the electrodes change according to a change in the amount of the nitrogen gas added to the sputtering gas.

The EL device according to the present invention is not limited to the embodiments and includes other types of structures.

For example, the EL device is not limited to an EL display device, and may be an EL lightning device. Also, the EL device is not limited to an inorganic EL device, but may be an organic EL device. When the device is of a top emission type, the lower electrode 11 may be a metal electrode with the above-described structure. The substrate 2 is not limited to the glass substrate 2, and may be a ceramic, a metal plate, etc. The metal electrode is not limited to a double layer, and may be a triple layer or more.

### INDUSTRIAL APPLICABILITY

### DESCRIPTION OF REFERENCE CHARACTERS

- 1: EL Display
- 1a: Display Section
- 1b: Terminal Section
- 2: Substrate
- 3: Element Film
- 4: Moisture-Proof Member
- 4a: Sealing Glass
- 4b: Silicon Oil
- 11: Lower Electrode
- 11a: Lower Strap Electrode
- 12: Upper Electrode
- 12a: Upper Strap Electrode
- 13: Group of Light Emitting Layers
- 14: Lower Insulating Layer
- 15: Light Emitting Layer
- 16: Upper Insulating Layer
- 20: Lower Layer (Aluminum Metal)
- 21: Upper Layer (Nickel Metal)
- 100: Plug (Body To Be Connected)
- 101: Connection Terminal

## Claims

1. An EL device, comprising:
a substrate;
a pair of electrodes provided one above the other on the substrate; and
a light emitting layer provided between the pair of electrodes, wherein
a voltage is applied between the pair of electrodes to emit light from the light emitting layer,
at least one of the pair of electrodes is a metal electrode,
the metal electrode is a multilayer including a lower layer of aluminum metal, and an upper layer of nickel metal formed above the lower layer, and
only the upper layer of the upper and lower layers contains a nitrogen element.

2. The EL device of claim 1, wherein
a thickness of the upper layer is set to 100 nm or more.

3. The EL device of claim 1 or 2, wherein
the upper layer is made of an alloy of nickel and copper.

4. The EL device of claim 1, further comprising
a terminal section connected to a body to be connected, which includes a connection terminal, in a removable manner, wherein
part of the metal electrode is provided in the terminal section in friction with the connection terminal.

5. A method of manufacturing the EL device of any one of claims 1-4, comprising the steps of:
forming a lower electrode, which is one of the pair of electrodes and is positioned lower, on the substrate;
forming the light emitting layer on the substrate provided with the lower electrode; and
forming an upper electrode, which is the other one of the pair of electrodes and is positioned higher, on the substrate provided with the lower electrode and the light emitting layer, wherein
at least one of the step of forming the lower electrode or the step of forming the upper electrode includes the steps of
sputtering for forming the aluminum metal layer and forming the nickel metal layer above the aluminum metal layer to form a multilayer film, and
etching for patterning the multilayer film, and
in the step of sputtering, nitrogen gas is added to sputtering gas only when forming the nickel metal film.

6. The method of claim 5, wherein
an additive amount of the nitrogen gas is set within a range of 1% to 30% by weight.

7. The method of claim 6, wherein
the additive amount of the nitrogen gas in the step of sputtering is set so that the aluminum metal film is etched at a rate substantially equal to a rate of the nickel metal film in the step of etching.

8. The method of claim 7, wherein
the additive amount of the nitrogen gas is set in a range of 6% to 8% by weight.
